(19) Europäisches Patentamt
European Patent Office
Office européen des brevets

(11) Veröffentlichungsnummer: **0 302 359 A2**

(12) **EUROPÄISCHE PATENTANMELDUNG**

(21) Anmeldenummer: **88112015.8**

(51) Int. Cl.[4]: **G03F 7/10**

(22) Anmeldetag: **26.07.88**

(30) Priorität: **04.08.87 DE 3725741**

(43) Veröffentlichungstag der Anmeldung: **08.02.89 Patentblatt 89/06**

(84) Benannte Vertragsstaaten: **AT BE CH DE FR GB IT LI NL**

(71) Anmelder: **HOECHST AKTIENGESELLSCHAFT**
**Postfach 80 03 20**
**D-6230 Frankfurt am Main 80(DE)**

(72) Erfinder: **Ruckert, Hans, Dr.-Chem.**
**Ersenacker 21**
**D-6200 Wiesbaden-Naurod(DE)**
Erfinder: **Lambert, Gabriele**
**Dreiweidenstrasse 1**
**D-6200 Wiesbaden(DE)**

(54) **Positiv arbeitendes strahlungsempfindliches Gemisch.**

(57) Es wird ein strahlungsempfindliches Gemisch beschrieben, das als wesentliche Bestandteile eine Verbindung, die unter Einwirkung von aktinischer Strahlung eine starke Säure liefert, ein wasserunlösliches, in organischen Lösemitteln und wäßrig-alkalischen Lösungen lösliches Bindemittel und eine Verbindung einer der Formeln I und II

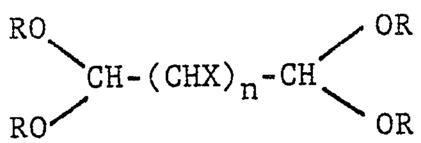

(I)

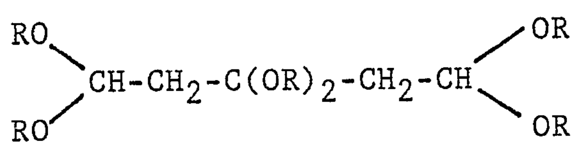

(II)

enthält, worin

R eine substituierte oder unsubstituierte Alkylgruppe,

X ein Wasserstoff- oder Halogenatom, eine Hydroxy-, Alkyl-, Alkoxy-, Alkoxycarbonyl-, Aryloxy- oder Arylgruppe und

n Null oder eine Zahl von 1 bis 3 bedeutet.

Das Gemisch ist zur Herstellung von Druckplatten und Photoresists geeignet und zeichnet sich durch höhere Flexibilität bei guter Entwicklerresistenz aus.

EP 0 302 359 A2

## Positiv arbeitendes strahlungsempfindliches Gemisch

Die Erfindung betrifft ein positiv arbeitendes, d. h. durch Bestrahlung löslich werdendes, strahlungsempfindliches Gemisch, das als wesentliche Bestandteile

a) eine bei Bestrahlung eine starke Säure bildende Verbindung,

b) eine Verbindung mit mindestens einer durch Säure spaltbaren C-O-C-Bindung und

c) ein in Wasser unlösliches, in wäßrig-alkalischen Lösungen lösliches Bindemittel enthält und zur Herstellung von Photoresists, elektronischen Bauelementen und Druckplatten sowie zum Formteilätzen geeignet ist. Gemische der genannten Zusammensetzung sind z. B. in den US-A 3 779 778; 4 101 323; 4 189 323; den DE-A 27 18 254; 29 28 636; 31 51 078 und den EP-A 0 006 626; 0 006 627; 0 022 571 und 0 042 562 beschrieben.

Bei Belichtung dieser Materialien wird durch Photolyse der Verbindung a) Säure gebildet, die die Spaltung von C-O-C-Bindungen der Verbindung b) bewirkt, so daß im Ergebnis die belichteten Bereiche der lichtempfindlichen Schichten im Entwickler löslich werden. Diese Stoffgemische sind jedoch nicht frei von Nachteilen.

Die bisher bevorzugten Polyacetale und Polyorthoester sind teilweise nicht leicht zugänglich und/oder besitzen die Eigenschaft - je nach den Kondensationsbedingungen - in unterschiedlicher Molekulargewichtsverteilung anzufallen. Dies beeinflußt sowohl die Gestehungskosten als auch die gewünschten Kopiereigenschaften, insbesondere die Konstanz der Lichtempfindlichkeit daraus hergestellter lichtempfindlicher Schichten. Diese bekannten lichtempfindlichen Gemische können nur bis zu einem gewissen Mengenanteil säurespaltbare Verbindungen aufnehmen; als Hauptbestandteil enthalten sie in der Regel ein wasserunlösliches, in wäßrigen Alkalien lösliches Bindemittel, das dem Gemisch eine ausreichende Entwicklerresistenz verleiht. Dieser große Mengenanteil an alkalilöslichem Bindemittel, vorzugsweise an Phenolharz, bewirkt aber, daß Schichten aus dem Gemisch, insbesondere bei höheren Schichtdicken, relativ spröde sind und zum Reißen oder Splittern neigen.

Es war bisher die herrschende Auffassung, daß für eine gute bildmäßige Differenzierung möglichst viele spaltbare C-O-C-Bindungen, d. h. polymere Verbindungen vorliegen müssen, wobei die C-O-C-Bindungen bevorzugt in der Hauptkette des Polymeren liegen sollten, so daß aus einem Polymermolekül viele kleine wesentlich besser lösliche Bruchstücke gebildet werden.

Aufgabe der Erfindung war es, ein strahlungsempfindliches Gemisch auf Basis von säurespaltbaren Verbin dungen mit hoher Strahlungsempfindlichkeit vorzuschlagen, das bei guter Entwicklerresistenz Schichten mit besserer Flexibilität bildet.

Erfindungsgemäß wird ein strahlungsempfindliches Gemisch vorgeschlagen, das als wesentliche Bestandteile

a) eine Verbindung, die unter Einwirkung von aktinischer Strahlung eine starke Säure liefert,

b) ein Acetal und

c) ein wasserunlösliches, in organischen Lösemitteln und wäßrig-alkalischen Lösungen lösliches Bindemittel enthält.

Das erfindungsgemäße Gemisch ist dadurch gekennzeichnet, daß das Acetal eine Verbindung einer der Formeln I und II

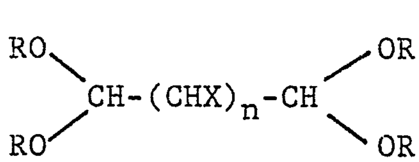

(I)

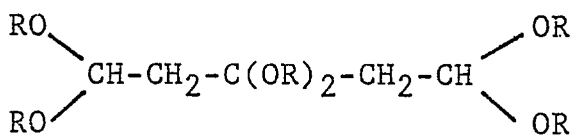

(II)

ist, worin

R eine substituierte oder unsubstituierte Alkylgruppe,

X ein Wasserstoff- oder Halogenatom, eine Hydroxy-, Alkyl-, Alkoxy-, Alkoxycarbonyl-, Aryloxy- oder Arylgruppe und

n Null oder eine Zahl von 1 bis 3 bedeutet.

Als aktinische Strahlung soll im Rahmen dieser Beschreibung jede Strahlung verstanden werden, deren Energie mindestens der des kurzwelligen sichtbaren Lichts entspricht. Geeignet ist insbesondere langwellige UV-Strahlung, aber auch Elektronen-, Röntgen- und Laserstrahlung.

Als flüssige Entwickler sind insbesondere schwach alkalische wäßrige Lösungen, ggf. im Gemisch mit organischen Lösemitteln, zu verstehen.

Die Tetraacetale der Formel I leiten sich ab von Dialdehyden und Monoalkoholen, bevorzugt primären Alkoholen. Geeignete Alkohole ROH sind solche, in denen R die folgende Bedeutung hat:

Alkyl, Alkoxyalkyl, Arylalkyl, Aryloxyalkyl und Polyalkoxyalkyl. R hat im allgemeinen 1 bis 20, vorzugsweise 2 bis 10 Kohlenstoffatome. Beispiele für geeignete Alkohole sind 2-Ethyl-butanol, 2-n-Butoxyethanol, Benzylalkohol, 2-Phenoxy-ethanol und 2-(2-n-Butoxy-ethoxy)ethanol.

In der Formel I ist n vorzugsweise 1 oder 2, insbesondere 1. X kann in allen Gliedern CHX ein von Wasserstoff verschiedener Substituent sein, vorzugsweise ist jedoch nicht mehr als ein X im Molekül von Wasserstoff verschieden. Als Substituenten X werden Halogenatome, insbesondere Chlor oder Brom, Hydroxygruppen und Alkylgruppen mit 1-3 Kohlenstoffatomen bevorzugt.

Von den Verbindungen der Formeln I und II sind einzelne einfache Vertreter bekannt, andere, insbesondere die Acetale von Alkoholen mit 3 und mehr Kohlenstoffatomen, sind bisher nicht beschrieben.

Die neuen spaltbaren Tetraacetale der Formel I kann man durch Umacetalisierung von käuflichen Tetramethyl- bzw. Tetraethylacetalen und ebenfalls käuflichen Alkoholen schnell, einfach und preiswert herstellen. Bei Verwendung des bevorzugten 1,1,3,3-Tetramethoxypropans (Malondialdehydtetramethylacetal) genügt schon die Reinheit des technischen Produkts. Beim Erhitzen der Komponenten mit einem geringen Alkohol-Überschuß in Gegenwart eines sauren Katalysators wie Toluolsulfonsäure oder vorteilhaft eines Montmorillonit-Ionenaustauschers, z. B. K 10 der Südchemie, der nach Beendigung der Umacetalisierung abfiltriert werden kann, wird kontinuierlich Methanol abdestilliert. Gegen Ende der Umacetalisierung wird, zweckmäßig unter Verwendung einer Fraktioniersäule, das restliche Methanol und dann unter Vakuum der Überschuß an Ausgangskomponenten abdestilliert. Im Ölpumpenvakuum können die erhaltenen Produkte meist analysenrein destilliert werden, was die vollständige Umacetalisierung zum Tetraacetal beweist. Im allgemeinen wird die Produktreinheit gaschromatographisch kontrolliert.

Beim anwendungstechnischen Vergleich konnte gezeigt werden, daß in den Kopiereigenschaften kein merklicher Unterschied zwischen destilliertem Endprodukt und dem nach Abdestillieren des Methanols und der Ausgangskomponenten erhaltenen Rohprodukt besteht; das im Kolben verbleibende Rohprodukt ist lediglich zumeist dunkler gefärbt. Wenn nur drei Methylethergruppen durch die eingesetzte Alkoholkomponente ersetzt sind, so unterscheiden sich die Eigenschaften eines solchen Mischacetals von denen des Tetramethylacetals.

Ferner zeigt sich, daß der optimale Mengenanteil an spaltbarer Substanz in dem erfindungsgemäßen Gemisch und damit die erreichbare Differenzierung zwischen belichteten und unbelichteten Schichtpartien in erheblichem Maße von der verwendeten Alkoholkomponente, insbesondere ihrer Größe und Hydrophilie, und der Wechselwirkung mit dem Bindemittel abhängt.

Analog ist der Einfluß der Struktur der Dialdehydkomponente. Die Derivate des Malondialdehyds werden im allgemeinen am günstigsten beurteilt und daher bevorzugt. Sie sind wahrscheinlich aus folgendem Grund graduell besser als die anderer Aldehyde. Bei der Acetalspaltung in der Schicht entstehen je Acetalmolekül 4 Moleküle der Alkoholkomponente und 1 Molekül Malondialdehyd. Bei der wäßrig-alkalischen Entwicklung kann der Malondialdehyd als Enolaldehyd ein leicht lösliches Salz bilden und dadurch einen wesentlichen Beitrag zur Bilddifferenzierung leisten.

Der optimale Mengenanteil an Acetal in dem erfindungsgemäßen Gemisch liegt insgesamt höher, d. h. meist bei 30 - 40 % im Vergleich zu ca. 15 - 25 % bei den bekannten oligomeren oder polymeren spaltbaren Verbindungen. Dies kann sich ebenfalls auf die Löslichkeitsdifferenz zwischen belichteten und unbelichteten Bereichen günstig auswirken und die mechanischen Eigenschaften der Schicht beeinflussen. So wird z. B. bei Trockenresists die Sprödigkeit verringert und die Flexibilität verbessert. Die optimale Menge liegt für Verbindung 5 bei ca. 40 - 45 %, bezogen auf Feststoff.

Allgemeines Merkmal der erfindungsgemäßen Gemische ist es, daß von den Spaltprodukten nach der Belichtung nicht nur die Alkoholkomponenten, sondern auch die Carbonylkomponenten zur Entwickelbarkeit im wäßrig-alkalischen Entwickler beitragen, weil sie als Enole und deren Salze leicht wasserlöslich sind. Die niederen Glieder dieser homologen Reihe Glyoxal und Malondialdehyd sind bereits wasserlöslich, mit steigender Kettenlänge sinkt die Enolisierbarkeit, so daß von den Verbindungen der Formel I diejenigen mit n = 1 bevorzugt werden. Die Enolisierbarkeit wird vom Substituenten X offenbar nicht wesentlich beeinflußt.

Die Malondialdehydverbindungen, die nicht mehr wasserlöslich sind, lösen sich in wäßrigen Alkalien auf.

Die Herstellung dieser Verbindungen und ihrer Acetale erfolgt analog zu bekannten Vorschriften. So kann Brommalondialdehyd durch Bromieren von Tetramethoxypropan und Verseifen (Chem. Ber. 95; 803 (1962)) hergestellt und durch Lösen in verdünnter Natronlauge und Ausfällen mit Salzsäure gereinigt werden. Andere Halogendialdehyde und die zugehörigen Acetale sind beschrieben in Houben-Weyl VI/Id, S. 34; Angew. Chem. 87 (1985) 124; Annalen 481; 17. Die Synthese der Alkyl-, Phenyl-, Alkoxy- und Ethoxycarbonylmalonaldehyde und einiger anderer Aldehyde bzw. ihrer Acetale erfolgt nach Houben-Weyl VI/Id, S. 35, Chem. Ber. 92; 1921 (1959); Chem. Ber. 95; 807 (1962); J. Chem. Soc. 1951; 2482. Methyldiformylacetat (2-Methoxycarbonyl-malonaldehyd) wird nach J.Am.Chem.Soc. 95, 543 (1973) erhalten. In Houben-Weyl 7/1, 417, 6/3, 220 und Synthesis 1981; 501 sind Herstellungsverfahren von Acetalen ausführlich beschrieben; in Houben-Weyl Band E3, 128, auch die Darstellung nach der neueren Trithianmethode.

Wie beim Tetramethoxypropan und dessen Umsetzung mit höheren Alkoholen unter Abspaltung von Methanol schon beschrieben, können die X-substituierten Malondialdehydmethyl- oder -ethylacetale analog umacetalisiert werden. Nach Abdestillieren des Methanols oder Ethanols kann der meist ölige Rückstand direkt eingesetzt werden.

Andere geeignete Acetale sind Derivate des 1,3-Diformylacetons, das zweimal enolisierbar und ebenfalls gut wäßrig-alkalisch löslich ist. Die Synthese führt von Diformylaceton (nach J. Indian Chem. Soc. 26; 568) oder über 4-Pyron direkt zum 1,1,3,3,5,5-Hexaethylacetal (Berichte 38 (1905); 1469). Analog wird über Pyron das Hexamethylacetal des Diformylacetons (Pentan-3-on-1,5-dial) hergestellt, das besonders für die Umacetalisierung mit höheren Alkoholen geeignet ist. Die Produkte gemäß der oben angegebenen Formel II mit mehr als 3 Kohlenstoffatomen im Rest R sind nur noch schwer destillierbar und werden daher direkt in der strahlungsempfindlichen Lösung eingesetzt.

Die spaltbaren Verbindungen können einzeln, im Gemisch untereinander und auch in Kombination mit bekannten säurespaltbaren Verbindungen eingesetzt werden. Auch ist es möglich, bei der Umacetalisierung bis zu etwa 30% der Alkoholkomponente durch Diole zu ersetzen. Dabei entstehen neben monomeren auch oligomere bis polymere Acetale der eingesetzten Dialdehyde, was zu höherer Viskosität der Produkte führt. Diol-Anteile über 50 % führen zu vernetzten Polyacetalen und damit zu Gelieren und Entwicklungsproblemen.

Zur Herstellung der erfindungsgemäßen positiv arbeitenden strahlungsempfindlichen Gemische werden die beschriebenen Acetale gemischt mit Substanzen, die photochemisch und bzw. oder durch Einwirkung von energiereicher Strahlung, besonders Elektronen- oder Röntgenstrahlung, Säuren bilden. Bei der Elektronenstrahlbebilderung von Halogenmalondialdehyd tetraacetalen ist der Zusatz eines Säurebildners nicht nötig, da diese Verbindungen beide Funktionen haben.

Die Gemische enthalten ferner ein polymeres, wasserunlösliches Bindemittel, das in organischen Lösemitteln löslich ist. Da sich als Entwicklerflüssigkeiten für die belichteten Kopierschichten mit Vorteil wäßrigalkalische Lösungen einsetzen lassen und diese im allgemeinen gegenüber Entwicklern auf Basis organischer Lösemittel vorgezogen werden, werden solche Bindemittel verwendet, die in wäßrigen Alkalien löslich oder mindestens quellbar sind.

Die Art und Menge der wasserunlöslichen Bindemittel kann je nach Anwendungszweck verschieden sein; bevorzugt sind Anteile am Gesamtfeststoff zwischen 30 und 80, besonders bevorzugt 50 - 75 Gew.-%.

Die bei vielen Positiv-Kopiermaterialien bewährten Phenolharze, vor allem Novolake, haben sich auch hier als besonders vorteilhaft erwiesen. Die Novolake können auch in bekannter Weise durch Umsetzung eines Teils ihrer Hydroxygruppen, z. B. mit Chloressigsäure, Isocyanaten, Epoxiden oder Carbonsäureanhydriden, modifiziert sein. Andere alkalilösliche Harze, wie Mischpolymerisate aus Maleinsäureanhydrid und Styrol, Vinylacetat und Crotonsäure, Methylmethacrylat und Methacrylsäure und dgl. sind ebenfalls als Bindemittel geeignet. Auch Mischpolymerisate von (Meth)acrylestern mit freien phenolischen OH-Gruppen sowie Homo- oder Mischpolymerisate von Vinylphenolen sind brauchbar.

Zusätzlich können noch zahlreiche andere Harze mitverwendet werden, die entweder wasserlöslich oder aber alkaliunlöslich sein können, z. B. Polyvinylacetate, Polyurethane, Polyacrylate, Polyvinylether und Polyvinylpyrrolidone, die selbst durch Comonomere modifiziert sein können, sowie hydrierte oder teilhydrierte Kolophoniumderivate. Der günstigste Anteil an diesen Harzen richtet sich nach den anwendungstechnischen Erfordernissen und dem Einfluß auf die Entwicklungsbedingungen und beträgt im allgemeinen nicht mehr als 20 Gew.-% vom alkalilöslichen Harz. In geringen Mengen kann die lichtempfindliche Schicht für spezielle Erfordernisse wie Flexibilität, Haftung, Glanz etc. außerdem noch Substanzen wie Polyglykole, Celluloseether, z. B. Ethylcellulose, Netzmittel und feinteilige Pigmente enthalten.

Als strahlungsempfindliche Komponenten, die beim Bestrahlen vorzugsweise starke Säuren bilden bzw. abspalten, sind eine große Anzahl von bekannten Verbindungen und Mischungen, wie Diazonium-,

Phosphonium-, Sulfonium und Jodonium-Salze, Halogen-Verbindungen, o-Chinondiazidsulfochloride und Organometall-Organohalogen-Kombinationen geeignet.

An Diazonium-Salzen kommen die in der Diazotypie bekannten Verbindungen mit ausnutzbarer Absorption zwischen 300 und 600 nm in Frage. Bevorzugt werden Verbindungen, die keine basischen Substituenten enthalten.

Die genannten Oniumsalze werden in der Regel in Form ihrer in organischen Lösungsmitteln löslichen Salze eingesetzt, meist als Abscheidungsprodukt mit komplexen Säuren wie Borfluorwasserstoffsäure, Hexafluorphosphor-, Hexafluorantimon- und -arsensäure.

Grundsätzlich sind als halogenhaltige strahlungsempfindliche und Halogenwasserstoffsäure bildende Verbindungen alle auch als photochemische Radikalstarter bekannten organischen Halogenverbindungen, beispielsweise solche mit mehr als einem Halogentom an einem Kohlenstoffatom oder an einem aromatischen Ring, brauchbar. Beispiele sind in den US-A 3 515 552, 3 536 489 und 3 779 778, der DE-B 26 10 842 und den DE-A 27 18 259 und 22 43 621 beschrieben.

Die Menge des Säurespenders kann je nach seiner chemischen Natur und der Zusammensetzung des Gemischs ebenfalls sehr verschieden sein. Günstige Ergebnisse werden erhalten mit etwa 0,1 bis 10 Gew.-%, bezogen auf den Gesamtfeststoff, bevorzugt sind 0,2 bis 5 %. Besonders für Kopierschichten von Dicken über 10 µm empfiehlt es sich, relativ wenig Säurespender zu verwenden.

Schließlich können dem lichtempfindlichen Gemisch noch lösliche oder feinteilige dispergierbare Farbstoffe sowie je nach Anwendungszweck auch UV-Absorber zugesetzt werden. Als Farbstoffe haben sich die Triphenylmethanfarbstoffe, insbesondere in der Form ihrer Carbinolbasen, besonders bewährt. Zur Erhöhung des Bildkontrasts nach der Belichtung werden die in der EP-A 224 161 beschriebenen Polymethinfarbstoffe bevorzugt.

Geeignete Lösemittel für das erfindungsgemäße Stoffgemisch sind Ketone wie Methylethylketon; chlorierte Kohlenwasserstoffe wie Trichlorethylen und 1,1,1-Trichlorethan, Alkohole wie n-Propanol, Ether wie Tetrahydrofuran, Alkoholether wie Propylenglykolmonoethylether und Ester wie Butylacetat oder 1-Ethoxy-propyl-2-acetat. Es können auch Gemische verwendet werden, die zudem noch für spezielle Zwecke Lösemittel wie Acetonitril, Dioxan oder Dimethylformamid enthalten können. Prinzipiell sind alle Lösemittel verwendbar, die mit den Schichtkomponenten nicht irreversibel reagieren.

Die Wahl der Lösemittel ist auf das vorgesehene Beschichtungsverfahren, die Schichtdicke und die Trocknungsvorrichtung abzustimmen. Dünne Schichten bis ca. 5µm werden für Versuchsmengen vorzugsweise auf der Schleuder durch Aufgießen aufgetragen. Mit Lösungen bis zu ca. 40 % Feststoffgehalt sind so mit einmaligem Auftrag oder mit einer Streichrakel Schichtdicken von mehr als 60µm erreichbar. Für beidseitige Beschichtung wird Tauchbeschichtung vorgezogen, wobei durch Verwendung von niedrigsiedenden Lösemitteln schnelles Antrocknen erreicht werden kann. Bandbeschichtung erfolgt durch Antragen mittels Walzen, Breitschlitzdüsen oder Sprühen; Einzelplatten können durch Gießerantrag (curtain-coater) beschichtet werden.

Bevorzugte Träger für Schichten von mehr als 10µm Dicke sind Kunststoffolien, die dann als temporäre Träger für Transferschichten dienen. Dafür und für Farbfolien werden Polyesterfolien bevorzugt. Als Schichtträger für Schichtdicken unter ca. 10µm werden meist Metalle verwendet. Für Offsetdruckplatten können eingesetzt werden: mechanisch oder elektrochemisch aufgerauhtes und ggf. anodisiertes Aluminium, das zudem noch chemisch, z. B. mit Polyvinylphosphonsäure, Silikaten oder Phosphaten, vorbehandelt sein kann, außerdem Mehrmetallplatten mit Cu/Cr oder Messing/Cr als oberster Schicht. Für Tiefdruck- oder Siebdruckformen eignen sich die erfindungsgemäßen Schichten durch ihre gute Haftung und Ätzfestigkeit auf Kupfer- bzw. Nickel-Oberflächen. Ebenso lassen sich die erfindungsgemäßen Gemische als Photoresists verwenden, wofür sie wegen ihrer guten Lagerfähigkeit in Lösung besonders geeignet sind.

Die Beschichtung kann direkt oder durch trockene Schichtübertragung vom temporären Träger erfolgen auf Leiterplattenmaterialien, die aus Isolierplatten mit einoder beidseitiger Kupferauflage bestehen, auf Glas oder Keramik-Materialien, die ggf. haftvermittelnd vorbehandelt sind, und auf Silizium-, Siliziumoxid- und Siliziumnitrid-Scheiben.

Für die Trocknung nach der Beschichtung können die üblichen Geräte und Bedingungen übernommen werden, Temperaturen um 100° C und kurzfristig bis 120° C werden ohne Einbuße an Strahlungsempfindlichkeit vertragen.

Zum bildmäßigen Belichten können die üblichen Kopiergeräte wie Röhrenlampen, Xenonimpulslampen, metallhalogeniddotierte Quecksilberdampf-Hochdrucklampen und Kohlenbogenlampen verwendet werden. Die Belichtung kann auch mit kohärentem Licht eines Lasers erfolgen. Geeignet für die Zwecke vorliegender Erfindung sind leistungsgerechte kurzwellige Laser, beispielsweise Argon-Laser, Krypton-Ionen-Laser, Farbstoff-Laser und Helium-CadmiumLaser, die zwischen 300 und 600 nm emittieren. Der Laserstrahl wird mittels einer vorgegebenen programmierten Strich- und/oder Raster-Bewegung gesteuert.

Das Bestrahlen mit Elektronenstrahlen ist eine weitere Bebilderungsmöglichkeit. Elektronenstrahlen können das erfindungsgemäße Gemisch wie auch viele andere organische Materialien durchgreifend zersetzen und vernetzen, so daß ein negatives Bild entsteht, wenn die unbestrahlten Teile durch Lösungsmittel oder Belichten ohne Vorlage und Entwickeln entfernt werden. Bei geringerer Intensität und/ oder höherer Schreibgeschwindigkeit des Elektronenstrahls bewirkt dagegen der Elektronenstrahl eine Differenzierung in Richtung höherer Löslichkeit, d. h. die bestrahlten Schichtpartien können vom Entwickler entfernt werden.

Die bildmäßig belichtete oder bestrahlte Schicht kann mit den gleichen Entwicklern wie für die bekannten Schichten auf Basis säurespaltbarer Verbindungen entfernt werden, bzw. die neuen Schichten können in ihren Kopierbedingungen vorteilhaft auf die bekannten Hilfsmittel wie Entwickler und programmierte Sprühentwicklungsgeräte abgestimmt werden. Die wäßrigen Entwicklerlösungen können z.B. Alkaliphosphate, -silikate oder -hydroxide und ferner Netzmittel sowie kleinere Anteile organischer Lösemittel enthalten. In bestimmten Fällen sind auch Lösemittel-Wasser-Gemische als Entwickler brauchbar. Die Wahl des günstigsten Entwicklers kann durch Versuche mit der jeweils verwendeten Schicht ermittelt werden. Bei Bedarf kann die Entwicklung mechanisch unterstützt werden.

Zur Erhöhung der Widerstandsfähigkeit beim Druck sowie der Resistenz gegen Auswaschmittel, Korrekturmittel und durch UV-Licht härtbare Druckfarben können die entwickelten Platten kurze Zeit auf erhöhte Temperaturen erwärmt werden, wie es für Diazoschichten aus der GB-A 1 154 749 bekannt ist. Auch eine Bildumkehr nach dem Verfahren der EP-A 82 463 ist möglich.

Erfindungsgemäß wird ferner ein Verfahren zur Herstellung von Reliefbildern vorgeschlagen, bei dem man ein strahlungsempfindliches Aufzeichnungsmmaterial aus einem Schichtträger und einer strahlungsempfindlichen Aufzeichnungsschicht, die aus dem oben definierten strahlungsempfindlichen Gemisch besteht, bildmäßig mit aktinischer Strahlung in solcher Dosis bestrahlt, daß die Löslichkeit der Schicht in einem flüssigen Entwickler zunimmt, und die bestrahlten Schichtteile mittels einer wäßrig-alkalischen Entwicklerlösung auswäscht.

In der folgenden Tabelle I sind Daten zur Herstellung einer Anzahl von Tetraacetalen der Formel I aufgeführt. Die Herstellung erfolgt, wie oben ausgeführt, analog zu bekannten Vorschriften. Als Ausgangsstoffe werden für die Verbindungen 1 bis 8 und 101,1,3,3-Tetramethoxypropan (TMP) vom Kochpunkt (Kp) 183 °C und für die Verbindung 9 das Tetraethoxyethan eingesetzt. Das Acetal wird bei 60-180 °C mit dem in der zweiten Spalte angegebenen Alkohol HOR umgesetzt und das entstandene Methanol bzw. Ethanol abdestilliert. Das erhaltene Produkt konnte bei den Verbindungen 1-4 und 8-10 destilliert werden, bei den Verbindungen 5-7 wurde der unter den angegebenen Bedingungen erhaltene Destillationsrückstand verwendet. Die Umacetalisierung wurde in Gegenwart von etwa 10 % Katalysator K 10 durchgeführt.

Die in Tabelle I beschriebenen neuen Tetraacetale sind durchnumeriert und kehren unter der gleichen Bezeichnung in den Anwendungsbeispielen wieder. In den Beispielen sind die Mengen zumeist in Gewichtsteilen (Gt) angegeben. Prozent-und Mengenverhältnisse sind in Gewichtseinheiten zu verstehen.

Tabelle I

| Verbindung Nr. | Alkohol HOR | Kp °C | Eingesetzte Molmenge HOR | Eingesetzte Molmenge Acetal (TMP) | $CH_3OH$-Abdestillation % | $CH_3OH$-Abdestillation nach Stunden | Produkt-Destillation Vakuum (mbar) | Produkt-Destillation KP °C | Analyse C ber. | Analyse C gef. | Analyse H ber. | Analyse H gef. | Aussehen |
|---|---|---|---|---|---|---|---|---|---|---|---|---|---|
| 1 | 2-Methoxy-ethanol | 124,5 | 6 | 0,75 | 73 | 3 | 0,27 | 135-138 | 52,9 | 52,8 | 9,4 | 9,8 | farblose Flüssigkeit |
| | | | | | 98 | 5 | | | | | | | |
| 2 | 2-Ethoxy-ethanol | 135-137 | 3,6 | 0,75 | 90 | 1 | 0,27 | 150-155 | | | | | farblose Flüssigkeit |
| 3 | 2-Butoxy-ethanol | 167-173 | 3,75 | 0,75 | 85 | 3 | 0,07 | 180-185 | 63,8 | 63,8 | 11,0 | 11,6 | hellgelbe Flüssigkeit |
| 4 | 2-Ethyl-butanol | 146-150 | 3,75 | 0,75 | 91 | 3 | 0,07 | 146-147 | 72,9 | 73,1 | 12,6 | 13,3 | farblose Flüssigkeit |
| 5 | 2-Phenoxy-ethanol | 237 | 2,15 | 0,43 | 71 | 4 | Kolben-Rückstand nach Abdestillieren bis 0,13 | 200 | 71,4 | 72,1 | 6,8 | 7,1 | dunkelbraune viskose Flüssigkeit |
| 6 | Benzylalkohol | 205 | 0,5 | 0,1 | 79 | 1 | Rückstand nach Abdestillieren bis 0,11 | 100 | 79,5 | 79,2 | 6,8 | 7,1 | dunkelbraune viskose Flüssigkeit |
| 7 | 2-(2-Butoxy-ethoxy)ethanol | 226-234 | 2,0 | 0,4 | 77 | 3 | Rückstand wie bei Nr. 5 | | 61,4 | 61,2 | 10,5 | 10,8 | dunkelbraune viskose Flüssigkeit |
| 8 | 2-(2-Methoxy-ethoxy)ethanol | 190-196 | 2,5 | 0,5 | 75 | 2 | 0,04 | 200-205 | 53,5 | 54,0 | 9,3 | 9,7 | hellgelbe ölige Flüssigkeit |
| 9 | 2-(2-Methoxy-ethoxy)ethanol | 190-196 | 2,0 | 0,4 (TEP) | 80 | 4 | 0,13 | 195-205 | 54,3 | 52,7 | 6,2 | 9,6 | hellgelbe ölige Flüssigkeit |
| 10 | 2-(2-Ethoxy-ethoxy)ethanol | 190-204 | 2,5 | 0,5 | 83 | 1,5 | 0,03 | 207-215 | 56,6 | 57,0 | 9,8 | 10,2 | hellgelbe ölige Flüssigkeit |

Beispiel 1

Für die Herstellung einer Offsetdruckplatte wird auf drahtgebürstetes Aluminium mittels Walzenantrag eine Beschichtungslösung aufgetragen aus

7,6 Gt eines Kresol-Formaldehyd-Novolaks mit dem Erweichungsbereich 105 - 120° C nach DIN 53181,
2,0 Gtder Verbindung Nr. 4,
0,3 Gt 2-(4-Methoxy-anthrac-1-yl)-4,6-bis-trichlormethyl-s-triazin und
0,1 Gt 4-Diethylamino-azobenzol in
90,0 Gt1-Ethoxy-propyl-(2)-acetat.

Die Lösung wird anschließend zu einer homogenen Schicht mit einem Schichtgewicht von 2,2 $g/m^2$ entsprechend ca. 2µm Dicke getrocknet.

Nach dem Trocknen wird unter einer positiven Vorlage belichtet, mit einer 3,5 %igen wäßrigen Lösung von Trinatriumphosphat entwickelt, die durch Zugabe von Natriumhydroxid auf ein pH von 12,6 eingestellt ist, dann mit Wasser abgespült und schließlich durch Überwischen mit 1 %iger Phosphorsäure druckfertig gemacht. Diese Platte zeigt schnelle Annahme der Druckfarbe und scharfe Bildwiedergabe.

Zum Vergleich wird eine entsprechende Offsetdruckplatte hergestellt, bei der die Verbindung Nr. 4 durch die gleiche Menge des Bis-2-tetrahydropyranylethers des 4,4′-Isopropylidendiphenols ersetzt worden ist. Diese Verbindung ist aus der DE-C 23 06 248 bekannt.

Bei gleicher Schichtdicke, Trocknung, Belichtung und Entwicklerlösung läßt sich die erfindungsgemäße Schicht ca. 5 Minuten nach der Belichtung in 60 s entwickeln, die Vergleichsschicht braucht 100 s. Der mitkopierte Halbton-Stufenkeil mit einem Dichteunterschied von $\sqrt{2}$ pro Stufe zeigt, daß die Vergleichsschicht um 1-2 Keilstufen unempfindlicher ist. Bei einer Wartezeit von über 3 Stunden zwischen Belichtung und Entwicklung und einer relativen Luftfeuchte von 55 % sind die Entwicklungszeiten 30 s bzw. 80 s für die Vergleichsschicht; die Keilstufendifferenz beträgt 4 Stufen. Die Unterschiede werden noch größer, wenn statt Verbindung Nr. 4 die Verbindung Nr. 5 der Tabelle verwendet wird.

Beispiel 2

Zur Herstellung eines Positiv-Trockenresists für Ätz- und Galvano-Anwendungen wird die folgende Lösung hergestellt:

55 Gt Butanon,
24,5 Gt Novolak wie in Beispiel 1,
20 Gt der Verbindung Nr. 5,
0,3 Gt 2-(4-Ethoxyethoxy-naphth-1-yl)-4,6-bis-trichlormethyl-s-triazin und
0,2 Gt Kristallviolett

Damit wird eine biaxial verstreckte und thermofixierte 25µm dicke Folie aus Polyethylenterephthalat, die mit Trichloressigsäure/Polyvinylalkohol vorbehandelt worden ist, so beschichtet und getrocknet, daß eine gleichmäßige ca. 25µm dicke Resistschicht entsteht. Die Oberfläche der Resistschicht wird mit einer 12µm dicken Polyethylenfolie kaschiert.

In einem handelsüblichen Laminator werden nach Abziehen der Deckfolie blanke Messingbleche zur Herstellung von Kontaktfedern für Schalter beidseitig mit dieser Schicht unter Druck und Wärme laminiert. Nach Abkühlen, Abziehen der Trägerfolie und kurzem Nachtrocknen im Trockenschrank bei 80° C wird mit einem deckungsgleichen Vorlagenpaar das beschichtete Blech beidseitig belichtet, wobei ein guter Bildkontrast entsteht. Anschließend wird an den entfärbten belichteten Stellen mit einer Lösung aus

0,5 % NaOH,
0,8 % Natriummetasilikat ·9 $H_2O$ und
1,0 % 2-n-Butoxy-ethanol in
97,7 % vollentsalztem Wasser

beidseitig sprühentwickelt, gespült und die Platten mit handelsüblicher Ferrichlorid-Lösung im Formteilätzverfahren solange geätzt, bis sie zu glatten Flanken durchgeätzt sind. Die so im Nutzen hergestellten

Formätzteile können vor dem Vereinzeln noch weiter bearbeitet, z. B. mittels Zweitkopie und Vergolden der Kontaktenden veredelt, in die gewünschte Form gebogen und entschichtet werden.

Im Vergleich zu einem 25µm dicken handelsüblichen Positiv-Trockenresist ist das erfindungsgemäße Material weniger spröde und daher auf diesem beweglichen und biegbaren Substrat ohne Risse verarbeitbar. Die relativ hohe Flexibilität der Schicht wird dadurch erreicht, daß sie bei einem Acetalgehalt von 40-50 % am Gesamtfeststoff gegenüber etwa 20 % bei üblichen Acetalen die günstigste Entwickelbarkeit und Entwicklerresistenz aufweist.

Wird in diesem Beispiel die Verbindung Nr. 5 durch die gleiche Menge (44,4 %, auf Festsubstanz bezogen) des bekannten Polyacetals aus 2-Ethyl-butyraldehyd und Triethylenglykol ersetzt, so wird beim Entwickeln die unbelichtete Bildschablone angegriffen, ehe die Entwicklung der belichteten Schichtbereiche beendet ist. Auch mit einem mit Wasser im Verhältnis 1:1 oder stärker verdünnten Entwickler werden unmittelbar nach Auflösen der belichteten Bereiche die Bildbereiche stark angegriffen, so daß eine ausreichende Bilddifferenzierung nicht möglich ist.

Beispiel 3

Das Beispiel zeigt die Anwendung eines Hexaacetals in einer Beschichtungslösung für Walzenantrag (roller-coater) bei der Herstellung von Feinleiterplatten. Das verwendete 1,1,3,3,5,5-Hexamethylacetal des Diformyl acetons wird analog dem in Ber. 38; (1905), 1469 beschriebenen Ethylacetal aus Pyron, Orthoameisensäuremethylester und Methanol hergestellt und fraktioniert destilliert Kp 70° C bei 0,33 mbar.

Elementaranalyse $C_{11}H_{24}O_6$:
ber.: 52,4 % C, 9,5 % H,
gef.: 52,7 % C, 10,0 % H.

Das Hexamethylacetal eignet sich auch gut als Ausgangsmaterial für Umacetalisierungen.

Die folgenden Schichtbestandteile

65 Gt Novolak wie in Beispiel 1,
7,5 Gt Polyvinylmethylether (Lutonal M 40),
27 Gt des oben bezeichneten Hexamethylacetals,
0,4 Gt 2-Acenaphth-5-yl-4,6-bis-trichlormethyl-s-triazin und
0,1 Gt Kristallviolettbase

werden in 1-Methoxy-propan-2-ol zu einer Lösung von 30% Feststoffgehalt gelöst. Man erhält eine Beschichtungslösung der Viskosität von etwa 90 mPas. Eine entsprechende Lösung von 40 % Feststoffgehalt hat eine Viskosität von ungefähr 200 mPas.

Beim Aufbringen dieser Lösung auf durchkontaktierte kupferkaschierte Isolierstoffplatten durch Walzenantrag, z. B. mit einem handelsüblichen Walzenantragsgerät (roller-coater), Typ AKL 400, der Firma Bürkle, Freudenstadt, Bundesrepublik Deutschland, zur doppelseitigen Beschichtung, das mit Gummi-Riffelwalzen mit 48 oder 64 Rillen je 2,5 cm (linear) ausgestattet ist, kann man je nach Resistlösung, Riffelwalze und Maschineneinstellung durch einmaligen Antrag Trockenschichtdicken von etwa 3 bis 14µm erhalten.

Nach dem Trocknen wird die Platte zunächst unter einer negativen Vorlage, die an den Lochbereichen transparent ist, belichtet, dann werden mit dem in Beispiel 2 angegebenen Entwickler diese Bereiche ausgewaschen, die Platte wird 10 Minuten bei 80° C getrocknet, dann an den freigelegten Lochbereichen galvanisch mit Kupfer verstärkt und verzinnt. Danach wird die Photoresistschicht unter einer positiven Leiterbahn-Vorlage belichtet und wie oben entwickelt. Das freigelegte Kupfer wird mit einem alkalischen Ätzmittel weggeätzt.

Ähnliche Ergebnisse werden erhalten, wenn man als spaltbares Acetal die entsprechende Hexaethylverbindung verwendet.

Wenn die durch Umacetalisieren mit 2-Ethoxy-ethanol und Abdestillieren von ca. 70 % der theoretischen Menge Methanol erhaltene Substanz eingesetzt wird, so liegt das Optimum der einzusetzenden Menge, bezogen auf Gesamtfeststoff, bei ca. 35 - 40 % statt der oben genannten 27 %. Außerdem wird dadurch die Schicht weicher und flexibler.

Beispiel 4

In diesem Beispiel sollen einige Unterschiede verschiedener Acetale gezeigt und verglichen werden. Dazu werden auf Silizium-Wafer mit folgender Positiv-Photoresistlösung feine Schaltungsmuster aufgebracht:

76 Gt 1-Methoxy-propan-2-ol,
14 Gt Novolak wie in Beispiel 1,
3 Gt Polyvinylethylether (Lutonal A 25),
1 Gt 2-(6-Methoxy-naphth-2-yl)-4,6-bistrichlormethyl-s-triazin,
6 Gt Acetal

Nach Aufschleudern dieser Lösung mit 6000 U/min und Nachtrocknen im Umlufttrockenschrank wird ein lagerfähiger, positiv vorsensibilisierter Wafer höherer Lichtempfindlichkeit, verglichen mit handelsüblichen Positiv-Photoresistschichten auf o-Naphthochinondiazid-Basis, z. B. dem handelsüblichen AZ 1350 J, erhalten.

Wenn als Acetal die Verbindung 8 der Tabelle eingesetzt wird, läßt sich mit dem zugehörigen handelsüblichen wäßrig-alkalischen (AZ)-Entwickler in maximal 2 Minuten ein sauberes Bild entwickeln. Beim Überentwickeln, d. h. bei der Entwicklerresistenzprüfung zur Beurteilung der Bilddifferenzierung, beginnt das Anlösen der nichtbelichteten Schichtpartien nach ca. 5 Minuten.

Wird als Acetal das käufliche 1,1,2,2-Tetraethoxyethan eingesetzt, so wird nach ca. 1 Minute Entwicklung ein positives Bild der Vorlage erhalten, aber mit schnellem Bildangriff, also geringer Entwicklerresistenz. Mit der daraus durch Umacetalisieren hergestellten Verbindung 9 der Tabelle beträgt die Entwicklungszeit bis zum Erscheinen eines positiven Bildes ca. 10 Minuten, die Entwicklerresistenz liegt zwischen 10 und 15 Minuten. Im direkten Vergleich von Verbindung 8 und 9 ist 8 eindeutig besser.

Werden als spaltbares Acetal statt vorstehender $C_2$- und $C_3$-Dialdehyd-Derivate die $C_5$-Derivate 1,1,5,5-Tetraethoxy-und -Tetra-n-butoxy-pentane, hergestellt nach der Vorschrift in J. Chem. Soc. 1951, 2480, eingesetzt, so lassen sich diese Schichten in ca. 5 bzw. ca. 7 Minuten bei guter Entwicklerresistenz entwickeln. Bei kürzerer Trocknung als üblich verringert sich die Entwicklungszeit auf Kosten der Resistenz, bei höherer verlängert sie sich so, daß der Entwickler, z.B. mit Natronlauge, aufgestärkt werden muß.

Schließlich wurde noch das käufliche $C_6$-Derivat Adipindialdehydtetraethylacetal in dieser Schicht geprüft und konnte auch noch zu einem positiven Bild innerhalb 8 Minuten entwickelt werden. Auch dies erreicht nicht die Qualität von Verbindung 8 und nicht die von Verbindung 9.

Beispiel 5

Auf eine mit ITO (Indium-Zinn-Oxid) durch Sputtern leitfähig transparent beschichtete Glasplatte für die Herstellung von Flüssigkristall-Anzeigeelementen (LCD) wird durch Walzenantrag eine nicht lichtempfindliche, aber elektronenstrahlempfindliche Schicht aus der folgenden Beschichtungslösung aufgetragen:

60 Gt eines Copolymeren aus 4-Hydroxystyrol und Hexylmethacrylat (OH-Zahl 290, RSV-Wert 0,55dl/g in Dimethylformamid),
19 Gt Bromacetal,
0,5 Gt Solvent Blue 5 (CI 61554)
0,5 Gt Kristallviolettbase, 120 Gt 1-Methoxypropan-2-ol

Nach dem Trocknen ist die Schicht ca. 5µm dick.

Wesentlich dabei ist die halogenhaltige Acetalverbindung, aus der bei Elektronenbeschuß Halogenwasserstoffsäure entsteht, welche katalytisch die Acetalgruppen verseift.

Das erste verwendete Bromacetal wird hergestellt durch Bromieren von käuflichem Malondialdehydbisdimethylacetal (1,1,3,3-Tetramethoxypropan) nach Chem. Ber. 93; 268 (1960). Dabei entsteht das der Enolform des Dialdehyds entsprechende 1,1,3-Trimethoxy-2-bromprop-2-en; ber. 37,9, gef. 37,6 % Br. Aus dieser Verbindung wird durch Umacetalisieren mit 2-Ethoxy-ethanol ein weiteres Bromacetal erhalten, das als Fraktion vom Kp = 98° C bei 0,31 mbar eingesetzt wird.
Analyse: gef. 29,8 % Br, ber. 29,8 % Br. Zum Vergleich wird Verbindung 2 der Tabelle, das Tetraethoxyethoxypropan bromiert (gef. 34,7 % Br) und diese Substanz ebenfalls in der obigen Photoresistlösung eingesetzt.

Die Schicht wird so lange mit 10 kV Elektronen bestrahlt, bis die Farbe fast völlig verschwindet und die späteren Leiterbahnen schon gut sichtbar sind. Das Bild mit dem ersten Bromacetal ist in 1 %iger Natronlauge in 20 Sekunden entwickelbar bei 1 Minute Bestrahlung einer Fläche von 10 $cm^2$ mit einem Strahlstrom von 10µA. Bei wesentlich höheren Energiedichten vernetzen die bestrahlten Partien und geben mit ca. 4 % Natronlauge als Entwickler ein negatives Bild.

Das zweite Bromacetal aus bromiertem Umacetalisierungsprodukt liefert bei einer Bestrahlung von mindestens 40 Sekunden je 10 $cm^2$ eine in 2 Minuten mit guter Differenzierung entwickelbare Schicht. Beim Bestrahlen mit UV-Licht geben beide Schichten kein Bild. Wird der Beschichtungslösung wie in den anderen Beispielen ein Photoinitiator, z. B. ein Bis-trichlormethyl-triazin zugegeben, so zeigen beide Schichten neben etwas erhöhter Elektronenstrahl-Empfindlichkeit wie zu erwarten auch UV-Lichtempfindlichkeit.

Nach Ätzen des ITO an den freigelegten Stellen mit 5 %iger Salzsäure und Entwickeln mit 5 %iger Kalilauge ist die Platte z. B. für eine 7-Segment-Ziffernanzeige fertig. Die blaue Grundeinfärbung dient der Verstärkung des Bildkontrasts bis zur Ätzung.

Nach der in CA 84; 164169 x (1976), bzw. CA 85; 20550 (1976) beschriebenen Methode kann das in Enolform als 2-Brom-1,1,3-trimethoxy-propen-2 formulierte Ausgangsprodukt dieses Beispiels durch Umsetzung mit Na-alkoholaten, z. B. Natriumethylat, zu 2-Hydroxymalondialdehydtetraethylacetal umgesetzt werden. Diese Verbindung und das nach Chem. Ber. 96; 2664 (1963) hergestellte 2-Methoxy-malondialdehydtetraethylacetal geben in vorstehender Rezeptur nur bei Zugabe von Photostarter eine Elektronen- und UV-Empfindlichkeit, die Entwicklerresistenz ist aber geringer als bei Acetalen mit größerem Alkoholrest.

<u>Beispiel 6</u>

Zur Herstellung autotypischer Tiefdruckzylinder werden Positiv-Photoresistlösungen der folgenden Zusammensetzung

40 Gt Trichlorethan,
40 Gt 1-Methoxypropan-2-ol,
5 Gt Acetal,
14,5 Gt Novolak wie in Beispiel 1,
0,3 Gt 2-(4-Styrylphenyl)-4,6-bis-trichlormethyl-s-triazin und
0,2 Gt Kristallviolettbase

durch Aufsprühen mit einer Preßluftpistole auf einen rotierenden Kupferzylinder ca. 6µm dick gleichmäßig aufgebracht, rotierend mit IR-Strahlung getrocknet, unter einem negativen autotypischen Tiefdruckfilm belichtet und wäßrig-alkalisch entwickelt. An den entsprechend der Vorlage flächenvariabel entwickelten Punkten zwischen den Tiefdruckstegen werden die Tiefdrucknäpfchen mit Ferrichloridlösung flächen- und tiefenvariabel geätzt. Vor dem Fertigmachen zum Druck wird die Resistschablone alkalisch entschichtet und der Zylinder verchromt.

Zur Herstellung eines gut haftenden und retuschierbaren Positiv-Photoresists wird eine auch oligomere Acetale enthaltende Mischung spaltbarer Verbindungen verwendet. Beim Umacetalisieren von 1,1,3,3-Tetramethoxypropan mit Triethylenglykol im Molverhältnis 1:2 und Abdestillieren des freiwerdenden Methanols entstehen zunehmend hochviskose bis gummiartige Kondensationsprodukte, die bei 25 % Zusatz, bezogen auf Feststoff, zu der folgenden Resistformulierung zunehmend weichere bis klebrige und schließlich nicht mehr lösliche und auch langsamer entwickelbare Schichten ergeben.

Ferner wird das Tetramethoxypropan im Molverhältnis 1:1:1 mit 2-n-Butoxy-ethanol und Triethylenglykol unter saurer Katalyse umacetalisiert, das freiwerdende Methanol abdestilliert und das Restgemisch mit wasserfreier Soda verrührt. Katalysator und Soda werden abfiltriert, und die viskose Substanz wird im Rotations verdampfer unter Vakuum bei Wasserbadtemperatur noch weiter konzentriert.

Durch Aufgießen von 1,5 %iger Natronlauge auf den rotierenden Zylinder wird die mit dem zuletzt beschriebenen Acetal erhaltene Schicht sauber entwickelt und dann geätzt. Bei mechanischer Behandlung der Schicht, z. B. Ziehen einer Linie mit einem Stichel, platzen deren Ränder im Gegensatz zu üblicherweise verwendeten Photoresists auf Basis Naphthochinondiazid kaum aus. Etwa ähnliche Ergebnisse werden erhalten, wenn anstelle dieses Mischacetals die weniger viskose Verbindung 3 der Tabelle eingesetzt wird.

Beispiel 7

Für die Herstellung von Offsetdruckplatten werden Aluminiumfolien mit elektrolytisch aufgerauhter und anodisierter Oberfläche mit lichtempfindlichen Lösungen folgender Grundrezeptur schleuderbeschichtet:

7,5 Gt Novolak wie in Beispiel 1,
2,3 Gt Acetal,
0,15 Gt 2-(4,7-Dimethoxy-naphth-1-yl)-4,6-bis-trichlormethyl-s-triazin und
0,05 Gt Kristallviolettbase in
90 Gt 1-Ethoxy-propan-2-ol

Nach dem Trocknen der Schichten (Schichtgewicht ca. 2,5 g/m$^2$) wird unter einer positiven Testvorlage belichtet, wie in Beispiel 1 entwickelt und druckfertig gemacht. Von jeder Druckplatte wird ein weiteres Muster in gleicher Weise verarbeitet, jedoch vor dem Entwickeln 10 Minuten auf 90° C erwärmt. Die Entwicklungszeit, Länge des Halbtonkeils und erreichbare Druckauflage werden verglichen.

Eingesetzt werden drei spaltbare Substanzen, die analog zum in Beispiel 3 eingesetzten Hexaethylacetal des Diformylacetons aus 4-Pyron hergestellt werden. Das Pyron wird einmal mit 2-Phenoxy-ethanol und einmal mit Polyethylenglykol-monomethylether umgesetzt, der 6-8 Ethylenoxideinheiten enthält. Außerdem wird zur Herstellung der dritten Substanz Tetramethoxypropan (TMP) mit dem angegebenen Polyglykolderivat umgesetzt.

Bei der ersten Synthese werden 0,015 mol Pyron und 0,15 mol 2-Phenoxy-ethanol in 0,05 mol Orthoameisensäureethylester mit einem kleinen Tropfen konzentrierter Schwefelsäure verrührt und 5 Tage bei Raumtemperatur stehengelassen. Ein Parallelansatz im Molverhältnis 1:6 wird ebenso verarbeitet, und ein weiterer Ansatz im Molverhältnis 1:10 wird eine Stunde am Rückfluß erhitzt. Anschließend werden alle Gemische mit einem geringen Überschuß von Natriumethylat neutralisiert und die flüchtigen Komponenten im Ölpumpenvakuum verdampft; der Rückstand wird ausgewogen und die Hexaacetal- bzw. Tetraacetal-Ausbeute, bezogen auf eingesetztes Pyron bzw. auf Polyglykolmethylether, berechnet. Das dritte Produkt wird wie üblich durch Umacetalisieren unter Abdestillieren des Methanols hergestellt. Alle Substanzen sind gelbbraune viskose Öle. Die damit erhaltenen Ergebnisse sind in der folgenden Übersicht dargestellt:

| | Rückstand % | Entwicklungszeit (sec) ungetemp. | Entwicklungszeit (sec) getemp. | Keilstufen frei ungetemp. | Keilstufen frei getemp. |
|---|---|---|---|---|---|
| 1. Pyron + Phenoxyethanol | | | | | |
| a) 1:10 RT, 5 Tage | >100 | 15 | 90 | 11 | 6 |
| b) 1: 6 " 5 " | 64 | 20 | 120 | 11 | 9 |
| c) 1:10 1h Rückfluß | >100 | 8 | 15 | 11 | 10 |
| 2. Pyron + Polyethylenglykolmethylether | | | | | |
| 1:6 RT, 5 Tage | 92 | 60 | 600 | 7 | 10 |
| 3. TMP + Polyethylenglykolmethylether | | | | | |
| 1:4, 1 h Rückfluß | 87 | 180 | 360 | 1 | 2 |

Alle vorstehenden Schichten zeigen ausreichende bis gute Entwicklerresistenz. Offensichtlich sind die Hexaacetal-Produkte mit Phenoxyethanol am lichtempfindlichsten, außerdem sind sie besser farbannehmend und zeigen im Druckversuch vergleichsweise höhere Auflagen als Schichten mit Substanz 2 und 3.

Beispiel 8

Es werden Positiv-Farbfolien z. B. für die Montagekontrolle im Mehrfarben-Offsetdruck hergestellt. Dazu wird als spaltbare Verbindung das Umacetalisierungsprodukt aus Tetramethoxypropan ($n_D$ = 1,407) und 1-Methoxypropan-2-ol ($n_D$ = 1,403) eingesetzt, das auch als Lösemittel verwendet wird.

Bei der Synthese wird dieses Gemisch im molaren Verhältnis 1 : 4 unter Zusatz von p-Toluolsulfonsäure als Katalysator am Rückfluß gekocht. Dann werden über eine Kolonne das bei der Umacetalisierung entstehende Methanol und danach die nicht umgesetzten Komponenten abdestilliert. Bei 0,4 mbar und ca. 127° C wird die Hauptfraktion des Produkts mit dem Brechungsindex $n_D$ = 1,448 gewonnen. Diese entspricht ca. 15 %, bezogen auf eingesetztes TMP, und wird im folgenden eingesetzt.

Die Kopierschichten haben die Zusammensetzung:

30 Gt des vorstehenden Tetraacetals,
48 Gt Novolak wie in Beispiel 1,
20 Gt Kolophoniumderivat vom Alkydharz-Typ (Neolyn(R)20 der Hercules Inc.),
0,5 Gt 2,5-Diethoxy-4-p-tolylmercapto-benzoldiazoniumhexafluorophosphat,
1,5 Gt Zaponechtblau HFL (C.I. 2880) oder
1,2 Gt Zaponechtrot BB (C.I. 2864) oder
2,0 Gt Fettgelb 5 G (C.I. Suppl. 572).

Die Schichtdicken zwischen 1 und 3 µm und die Farbstoffmengen werden so aufeinander abgestimmt, daß die Rot-, Blau- und Gelbfolie die gleiche Lichtempfindlichkeit aufweisen, d. h. bei sowohl gleicher Belichtungszeit als auch Entwicklungszeit mit 0,6 % Natronlauge gleich lange Keilstufen bei einem mitkopierten Halbton-Testkeil ergeben. Diese kratzfesten Farbfolien sind mehr als doppelt so lichtempfindlich wie Vergleichsprodukte auf Basis von o-Naphthochinondiaziden.

Beispiel 9

Dieses Beispiel zeigt die Anwendung einer 15 µm dicken Positiv-Trockenresistschicht für die Ätzung von Leiterbahnen auf Multilayer-Innenlagen. Dafür wird ein spaltbares Tetraacetal eingesetzt, das wie folgt hergestellt wurde:

Aus Methyl-3,3-dimethoxypropionat, hergestellt nach J. Am. Chem. Soc. 71, 1257 (1949), wurde analog J. Am. Chem. Soc. 95, 543 (1973) zunächst der 2-Methoxycarbonyl-malonaldehyd (= Methyldiformylacetat) synthetisiert. Abweichend von dieser Vorschrift wurde in t-Butylmethylether statt getrocknetem Diethylether formyliert und unter Stickstoff anstelle von Argon gearbeitet. Die erhaltene hellgelbe ölige Flüssigkeit zeigte die angegebenen IR-Banden.

Zur Herstellung des gewünschten Tetraacetals wird der 2-Methoxycarbonyl-malondialdehyd in einer Eintopfreak tion über das Methylacetal zum Acetal mit 2-Phenoxyethanol umgesetzt. Dazu werden in einem Kolben 0,1 mol = 13,0 g 2-Methoxycarbonyl-malonaldehyd, 0,22 mol Orthoameisensäure-trimethylester und 0,4 mol 2-Phenoxy-ethanol verrührt und ca. 0,2 g K 10-Katalysator oder p-Toluolsulfonsäure unter schwachem Erwärmen dazugegeben. Bei langsam steigender Temperatur geht zuerst Methylformiat (Kp 31 °C) und dann ein Methylformiat-Methanol-Gemisch über, der Rest wird unter Vakuum bis 1,3 mbar und 100 °C abdestilliert. Das verbleibende gelbe Öl wird direkt eingesetzt.

Eine Beschichtungslösung aus

19 g dieses öligen Tetraacetals,
25,5 g Novolak wie in Beispiel 1,
0,2 g 2-(4-Styrylphenyl)-4,6-bis-trichlormethyl-s-triazin,
0,1 g Solvent Blue 5 (CI 61 554),
0,2 g Säureviolett 520 (Riedel de Haen) in
55 g Butanon

wird auf eine Folie wie in Beispiel 2 beschrieben aufgebracht und zu einer ca. 15 µm dicken Positiv-Trockenresistschicht getrocknet. Nach Laminieren auf die flexiblen Multilayer-Innenlagen-Substrate, Abziehen der Trägerfolie und 5 Minuten Nachtrocknen bei 80 bis 90 °C wird unter einer positiven Vorlage belichtet, mit 1 %iger Natronlauge innerhalb 1 Minute sprühentwickelt und in einem ammoniakalischen Ätzbad von pH = 8,4 das freigelegte Kupfer weggeätzt und abschließend die Resistschablone bei

Raumtemperatur mit 5 %iger KOH entschichtet.

Der verwendete sehr lichtempfindliche Photoresist zeigt beim Biegen auf dem flexiblen Substrat keine Risse und daher keine Durchätzungen, obwohl er auf dem spröden Novolakharz basiert. Die eingesetzte spaltbare Acetalverbindung wirkt als Weichmacher und zeigt in der im Beispiel verwendeten Menge von 42 % vom Feststoff gute Entwicklungs- und Resistenz-Eigenschaften. Bei geringerem Acetalgehalt verlängert sich die Entwicklungszeit. Dieser Photoresist zeigt außerdem guten Bildkontrast sowohl nach dem Belichten als auch nach dem Entwickeln auf dem Kupferuntergrund. Zudem ist eine Zweitbelichtung und -entwicklung möglich, ebenso wie eine Negativ-Verarbeitung nach dem Umkehrverfahren.

Ein praktisch gleiches Ergebnis mit anderem Farbton der Photoresistschicht wird erhalten, wenn man die 0,2 g Säureviolett 520 durch 0,1 g Kristallviolettbase ersetzt.

**Ansprüche**

1. Strahlungsempfindliches Gemisch, das als wesentliche Bestandteile

a) eine Verbindung, die unter Einwirkung von aktinischer Strahlung eine starke Säure liefert,
b) ein Acetal und c) ein wasserunlösliches, in organischen Lösemitteln und wäßrig-alkalischen Lösungen lösliches Bindemittel

enthält, dadurch gekennzeichnet, daß das Acetal eine Verbindung einer der Formeln I und II

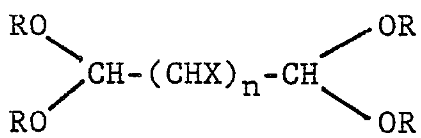

(I)

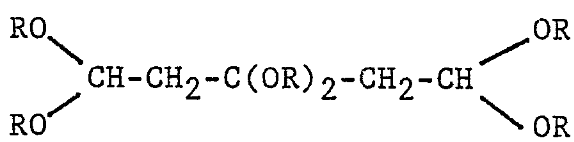

(II)

ist, worin
R eine substituierte oder unsubstituierte Alkylgruppe,
X ein Wasserstoff- oder Halogenatom, eine Hydroxy-, Alkyl-, Alkoxy-, Alkoxycarbonyl-, Aryloxy- oder Arylgruppe und
n Null oder eine Zahl von 1 bis 3 bedeutet.

2. Strahlungsempfindliches Gemisch nach Anspruch 1, dadurch gekennzeichnet, daß n 1 oder 2 ist.

3. Strahlungsempfindliches Gemisch nach Anspruch 1, dadurch gekennzeichnet, daß in der Verbindung der Formel I nicht mehr als ein X von Wasserstoff verschieden ist.

4. Strahlungsempfindliches Gemisch nach Anspruch 1, dadurch gekennzeichnet, daß R 2 bis 10 Kohlenstoffatome enthält.

5. Strahlungsempfindliches Gemisch nach Anspruch 1, dadurch gekennzeichnet, daß es 25 bis 60 Gew.-%, bezogen auf seine nichtflüchtigen Bestandteile, Acetal enthält.

6. Strahlungsempfindliches Gemisch nach Anspruch 1, dadurch gekennzeichnet, daß es 30 bis 80 Gew.-% Bindemittel enthält.

7. Strahlungsempfindliches Gemisch nach Anspruch 1, dadurch gekennzeichnet, daß es 0,1 bis 10 Gew.-% bei Bestrahlung Säure liefernde Verbindung enthält.

8. Strahlungsempfindliches Aufzeichnungsmaterial aus einem Schichtträger und einer strahlungsempfindlichen Aufzeichnungsschicht, die als wesentliche Bestandteile

a) eine Verbindung, die unter Einwirkung von aktinischer Strahlung eine starke Säure liefert, b) ein Acetal und c) ein wasserunlösliches, in organischen Lösemitteln und wäßrig-alkalischen Lösungen lösliches

Bindemittel

enthält, dadurch gekennzeichnet, daß das Acetal eine Verbindung einer der Formeln I und II

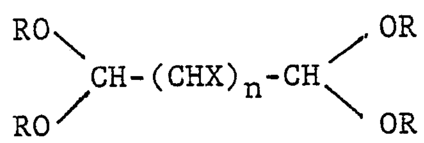

(I)

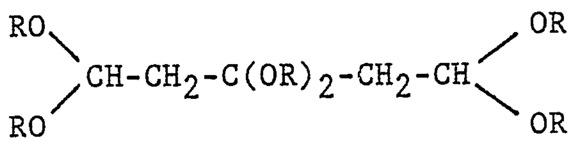

(II)

ist, worin

R eine substituierte oder unsubstituierte Alkylgruppe,

X ein Wasserstoff- oder Halogenatom, eine Hydroxy-, Alkyl-, Alkoxy-, Alkoxycarbonyl-, Aryloxy- oder Arylgruppe und

n Null oder eine Zahl von 1 bis 3 bedeutet.

9. Verfahren zur Herstellung von Reliefbildern, bei dem man ein strahlungsempfindliches Aufzeichnungsmaterial gemäß Anspruch 8 bildmäßig mit aktinischer Strahlung in solcher Dosis bestrahlt, daß die Löslichkeit der Schicht in einem flüssigen Entwickler zunimmt, und die bestrahlten Schichtbereiche mittels einer wäßrig-alkalischen Entwicklerlösung auswäscht.